(19) Europäisches Patentamt

European Patent Office

Office européen des brevets

(11) **EP 4 765 620 A1**

(12) **EUROPEAN PATENT APPLICATION**

(43) Date of publication:
**24.06.2026 Bulletin 2026/26**

(21) Application number: **25223018.0**

(22) Date of filing: **12.12.2025**

(51) International Patent Classification (IPC):
**H02P 3/22** (2006.01)   **B60L 3/00** (2019.01)
**G01R 31/52** (2020.01)   **H02P 29/024** (2016.01)

(52) Cooperative Patent Classification (CPC):
**H02P 29/024; B60L 3/0061; G01R 31/52;**
**H02P 3/22**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **20.12.2024 GB 202418881**

(71) Applicant: **HITACHI RAIL LIMITED**
**London Greater London EC4M 7AW (GB)**

(72) Inventors:
• **KIMURA, Shunsuke**
  **London EC4M 7AW (GB)**
• **DAUTEL, Christopher**
  **London EC4M 7AW (GB)**

(74) Representative: **Mewburn Ellis LLP**
**Aurora Building**
**Counterslip**
**Bristol BS1 6BX (GB)**

(54) **DRIVE SYSTEM, VEHICLE, AND METHOD**

(57)    A drive system 100. The drive system 100 comprises: a main power supply 03; a converter 04, configured to receive power from the main power supply and provide a multi-phase driving current; a permanent magnet motor 08a, 08b, 08c, 08d, configure to receive the multi-phase driving current; one or more contactors 06a, 06b located between the converter and the permanent magnet motor, configured to selectively isolate the permanent magnet motor from the converter; a voltage sensor 07a, 07b, configured to sense a voltage between one or more pairs of phases of the multi-phase driving current at a position between the one or more contactors and the permanent magnet motor; and a controller 05, configured, whilst the one or more contactors are open, to receive the sensed voltage(s) from the voltage sensor and detect a short-circuit fault of the permanent magnet motor on the basis of the received sensed voltage(s).

Fig. 1

# Description

## TECHNICAL FIELD

The present disclosure relates to a drive system, a vehicle, and a method.

## BACKGROUND

Traction motors are used for variable speed drive systems, such as electric cars and railway vehicles (e.g., locomotives). Mainly these tractions motors are implemented either as induction motors or synchronous motors. Conventionally, induction motors have been used. However, synchronous motors, particularly permanent magnet synchronous motors (PMSMs) are also being introduced in order to further improve efficiency and reduce energy consumption.

As PMSMs contain permanent magnets, they generate an induced voltage when rotating. Therefore, in order to protect components from this induced voltage, contactors are implemented within the circuit to electrically isolate the motor when required.

However, the inventors have noted an issue in that where there is a short circuit downstream of the contactor (i.e., between the contactor and the traction motor), a short circuit current will continue to flow as the motor generates an induced voltage even when the contactor is open.

The present disclosure was arrived at in light of the above considerations.

## SUMMARY

Accordingly, in a first aspect, embodiments of the invention provide a drive system, the drive system comprising:

> a main power supply;
> a converter, configured to receive power from the main power supply and provide a multi-phase driving current;
> a permanent magnet motor, configured to receive the multi-phase driving current;
> one or more contactors located between the converter and the permanent magnet motor, configured to selectively isolate the permanent magnet motor from the converter;
> a voltage sensor, configure to sense a voltage between one or more pairs of phases of the multi-phase driving current at a position between the one or more contactors and the permanent magnet motor; and
> a controller, configured, whilst the one or more contactors are open, to receive the sensed voltage from the voltage sensor and detect a short-circuit fault of the permanent magnet motor on the basis of the received sensed voltage.

Such a drive system can detect a short-circuit fault in the permanent magnet motor even when the contactors are open.

The controller may be configured to detect the short-circuit fault by comparing a waveform in the received sensed voltage for the or each pair of phases to a predetermined healthy waveform. The predetermined healthy waveform may be one that can be observed when no short-circuit fault occurs between the or each pair of phases, and it may be stored in memory of the controller. Comparing the waveform in the received sensed voltage for the or each pair of phases may include calculating a distortion rate of the respective waveform, and comparing the distortion rate to a threshold corresponding to the predetermined healthy waveform. Any calculation methods can be applied, so long as it can be used to determine by how much the shapes of the waveform in the sensed voltage and the predetermined normal waveform differ, such as a distortion rate. The distortion rate may be calculated using the equation:

$$THD[\%] = \frac{\sqrt{\Sigma(V_k)^2}}{V_1} \times 100$$

where *THD* (Total Harmonic Distortion) indicates the distortion rate, $V_1$ is the fundamental frequency factor of the voltage, and $V_k$ is the $k^{th}$ factor of the voltage ($k \geqq 2$) such as the effective voltages of the harmonic components at integer multiples of the fundamental frequency. For example, where the motor is being driven at 50Hz, this will form the fundamental frequency. If there is a short-circuit fault, it is expected that the term $V_1$ for the relevant phases will decrease, and so the *THD* will be high. In contrast, the *THD* value will be lower where the waveform is indicative of a healthy waveform. The $V_k$ term may be derived by application of a fast Fourier transform to the measured voltage, to derive each factor (from 1 to a $k^{th}$ factor, e.g., $30^{th}$). In some examples, a *THD* in excess of 10% may indicate an abnormal waveform and therefore a short-circuit fault.

The distortion rate may be calculated for each phase pair, and each calculated distortion rate will then be compared to the predetermined threshold, such as 10%, to ascertain if there is a short-circuit fault between that phase pair.

The drive system may include a plurality of permanent magnet motors, each separated from the converter by one or more contactors. The contactors may be shared between permanent magnet motors, or each permanent magnet motor may have its own respective contactors. In such a drive system, there may be a plurality of voltage sensors, one for each permanent magnet motor, and so configured to sense a voltage between one or more pairs of the multi-phase driving current at a point between the one or more contactors and the respective permanent magnet motor. The controller may therefore receive sensed voltages(s) from each of the voltage sensors, and detect a respective short-circuit fault in each of the permanent magnet motors.

The drive system may further comprise a temperature sensor configured to sense a temperature of the permanent magnet motor, and the controller may be configured to receive the sense temperature from the temperature sensor and detect or verify a short-circuit fault of the permanent magnet motor on the basis of the received sensed temperature. The controller may be configured to drive a rate of change of temperature with respect to time, and to detect or verify the short-circuit fault of the permanent magnet motor by comparing the rate of change of temperature with respect to a predetermined rate that indicates there exists no short-circuit fault.

The controller may be further configured to detect a motor rotor position and/or rotor speed based on the received sensed voltage(s). For example, the received sensed voltage may be divided into d-q coordinates (in general, this is referred to as a d-q coordinate transform). The controller may further be configured to monitor the motor current, and so calculate each d/q axis induced voltage using the current, monitor impedance, and inductance value (known in advanced and stored in the controller). The controller can then compare the estimated d-q voltage and the received sensed voltage and use the phase gap to detect the rotor position and/or speed.

The controller may be configured to repeatedly receive the sensed voltage(s) from the voltage sensor, and detect from each received sensed voltage whether a short-circuit fault is detected. The controller may continuously receive the sensed voltage, when it is directly connected to the voltage sensor and the voltage sensor provides an analogue signal. The detection may be performed periodically, for example at a rate of 100 Hz (or every 10 ms).

The controller may be further configured, whilst the one or more contactors closed, to:

receive the sensed voltage(s) from the voltage sensor and detect a short-circuit fault on the basis of the received sensed voltages,
responsive to detecting the short-circuit fault whilst the contactors are closed, open the one or more contactor; and
attempt to redetect the short-circuit fault after the one or more contactors are opened, and
responsive to redetecting the short-circuit fault, detect the short-circuit fault is present in the permanent magnet motor, or
responsive to failing to redetect the short-circuit fault, detect the short-circuit fault is present between the converter and the one or more contactors. -Responsive to determining the short-circuit fault is present between the converter and the one or more contactors, the controller may be configured to disconnect the main power supply from a source power supply.

For example, when the drive system is integrated into a train, the controller may disconnect a main transformer (providing the main power supply) from an overhead catenary (providing the source supply) by lowering a pantograph.

The controller may be configured to issue an alert when it detects the short-circuit fault. The alert may be to a driver assistance system, for example a driver console in a railway vehicle.

The converter may be configured to provide a three-phase driving current, such as V, U and W phases, the voltage sensor may be configured to sense the voltage between each pair of phases of the three-phase driving current and the one or more contactors may be a three-phase contactor configured to operate on all the three phases at the same time. The sensing may be direct or indirect. For example, the voltage sensor may directly sense a V-U, V-W, and U-W voltage. Alternatively, the sensing may be at least partially indirect. For example, the voltage sensor may directly sense a V-U and V-W voltage and infer from this the U-W voltage. The inferred voltage may be arrived at by subtracting the absolute magnitude of one of the measured voltages from the absolute magnitude of the other of the measured voltages, e.g., $|U - W| = |V - U| - |V - W|$.

In a second aspect, embodiments of the invention provide a vehicle comprising the drive system of the first aspect and optionally including any one or any combination insofar as they are compatible of the optional features of the first aspect.

The vehicle may further comprise a wheel, a mechanical brake, and a brake controller, wherein the brake controller is configured to active the mechanical brake to apply a braking force to the wheel based on a signal received from the controller when it detects the short-circuit fault. The braking force which can be applied by the mechanical brake may be independent of the permanent magnet motor, such as a pneumatic brake.

The vehicle may be a railway vehicle. The railway vehicle may form a part of a train, and may be a locomotive. The vehicle may be a car which has the drive system consists of the permanent magnet motor to drive, such as an electric car, bus or truck.

In a third aspect, embodiments of the invention provide a method of detecting a short-circuit fault in a permanent magnet motor for a drive system, the method comprising:

receiving a sense voltage between one or more pairs of phases of a multi-phase driving current at a position between one or more contactors and the permanent magnet motor, the contactor(s) being between a converter and the permanent magnet motor and the converter receiving power from a main power supply and providing the multi-phase driving current; and
detecting, whilst the one or more contactors are open, from the sensed voltage(s), a short-circuit fault of the permanent magnet motor.

The method may be computer-implemented, and may be performed by a controller (e.g., the controller of the first aspect). The method may be repeated, so as to repeatedly receive the sensed voltage(s) from the voltage sensor, and detect from each received sensed voltage whether a short-circuit fault is detected. The sensed voltage may be continuously received, when it is directly connected to the voltage sensor and the voltage sensor provides an analogue signal. The detection may be performed periodically, for example at a rate of 100 Hz (or every 10 ms).

The method may be performed using or on the drive system of the first aspect, and optionally including any one or any combination insofar as they are compatible of the optional features set out with reference thereto.

In a fourth aspect, embodiments of the invention provide a drive system, the drive system comprising: a main power supply; a converter, configured to receive power from the main power supply and provide a multi-phase driving current; a permanent magnet motor, configured to receive the multi-phase driving current; one or more contactors between the converter and the permanent magnet motor, configured to selectively isolate the permanent magnet motor from the converter; a temperature sensor, configured to sense a temperature of the permanent magnet motor; and a controller, configured to receive the sensed temperature and to detect a short-circuit fault of the permanent magnet motor on the basis of the received sensed temperature.

The controller may be configured to derive a rate of change of temperature with respect to time, and to detect or verify the short-circuit fault of the permanent magnet motor by comparing the rate of change of temperature with respect to a healthy value.

The drive system of the fourth aspect may further comprise a voltage sensor configured to sense a voltage between one or more pairs of phases of the multi-phase driving current at a position between the one or more contactors and the permanent magnet motor.

The controller of the fourth aspect may be configured to receive the sensed voltage(s) from the voltage sensor, and subsequent to a detection from the sensed temperature that there is a short-circuit fault of the permanent magnet motor on the basis of the sensed temperature, further detect or verify the short-circuit fault on the basis of the received sensed voltage(s). This further detection or verification may include identifying which phases of the multi-phase driving current are shorted.

In a fifth aspect, embodiments of the invention provide a method of detecting a short-circuit fault in a permanent magnet motor, the method comprising: receiving a sensed temperature of a permanent magnet motor; and detecting, from the sensed temperature, a short-circuit fault of the permanent magnet motor.

The invention includes the combination of the aspects and preferred features described except where such a combination is clearly impermissible or expressly avoided. For example, the controller of the fourth aspect may be configured to detect the short-circuit fault on the basis of the received sensed voltage(s) using any of the features set out with reference to the controller of the first aspect.

Further aspects of the present invention provide: a computer program comprising code which, when run on a computer, causes the computer to perform the method of the third or fifth aspect; a computer readable medium storing a computer program comprising code which, when run on a computer, causes the computer to perform the method of the third or fifth aspect; and a computer system programmed to perform the method of the third or fifth aspect.

### BRIEF DESCRIPTION OF THE DRAWINGS

Fig. 1 shows a vehicle including a drive system;
Fig. 2 shows a partial drive system;
Fig. 3 shows a plot of voltage against time;
Fig. 4 shows the partial drive system of Fig. 2 in a U-V short-circuit condition;
Fig. 5 shows the sensed voltages for the condition in Fig. 4;
Fig. 6 shows the partial drive system of Fig. 2 in a V-W short-circuit condition;
Fig. 7 shows the sensed voltages for the condition in Fig. 6;
Fig. 8 shows the partial drive system of Fig. 2 in a U-W short-circuit condition;
Fig. 9 shows the sensed voltages for the condition in Fig. 8;
Fig. 10 shows a flow diagram;
Fig. 11 shows a variant partial drive system;
Fig. 12 shows a plot of temperature against time;
Fig. 13 shows the variant partial drive system of Fig. 11 in a U-V short-circuit condition;
Fig. 14 shows a plot of temperature against time during the U-V short-circuit condition in Fig. 13; and
Fig. 15 shows a flow diagram.

### DETAILED DESCRIPTION

Aspects and embodiments of the present invention will now be discussed with reference to the accompanying figures. Further aspects and embodiments will be apparent to those skilled in the art.

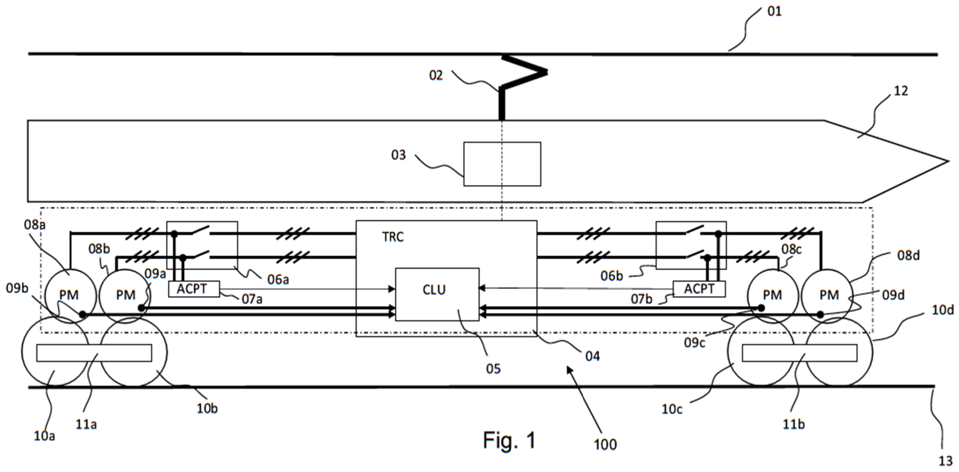

Fig. 1 shows a vehicle 12, in this example a railway vehicle traveling on a track 13, including a drive system 100 which consists of traction functionality or components for converting electrical power into mechanical or kinetic power. The railway vehicle in this example uses a pantograph 02 to obtain power from an overhead catenary 01, although in other examples power may be obtained from on-board energy storage systems (e.g., batteries or capacitors) or may be generated using a generator (e.g., a diesel genset). The received power is provided to high voltage equipment 03. In examples where the railway vehicle is powered by the catenary, the high voltage equipment may include a high speed circuit breaker (when the catenary provides DC current) or a vacuum circuit breaker and a main transformer (when the catenary provides an AC current).

This main power is then provided to a traction converter unit 04, for example an inverter (when the main power is AC power). In some examples, the traction converter unit may include an AC - AC converter, or a DC - AC converter. Included as a part of the traction converter unit 04 is a control logic unit 05 (also referred to as a controller) which controls the operation of the traction converter unit. The traction converter unit provides a multi-phase output current to, in this example four, PMSMs (permanent magnet synchronous motors) 08a - 08d. These motors use the driving current to turn respective wheels 10a - 10d which are situated on one or more bogies 11a, 11b. The wheels may include mechanical brakes such as pneumatic brakes (not shown) which can apply braking force to the wheels according to a signal from a brake controller (not shown). The brake controller is configured to active the mechanical brakes through a train system (not shown) which can connect to the control logic unit and the brake controller. Between the PMSMs and the traction converter unit are contactors boxes 06a and 06b which contain a number of contactors for selectively isolating the PMSMs from the traction converter unit. In this example, one contactor box contains the contactors for two PMSMs.

The drive system also includes voltage sensors 07a, 07b (where ACPT stands for alternating current potential transformer). The voltage sensors are configured to sense a voltage of the multi-phase, such as three-phase consists of U, V and W phase, driving currents provided by the traction converter unit 04 at a position between a set of contactors and the respective PMSM. For example, voltage sensor 07b is located between the contactors disposed in the contactor box 06b and the PMSMs 08c and 08d. In this example, each voltage sensor is configured to sense the voltage of two of the three pairs of phases (U-V and V-W). These sensed voltages are provided to the control logic unit 05. The drive system also includes temperature sensors 09a - 09d, each located in proximity to and so able to sense the temperature of a respective PMSM 08.

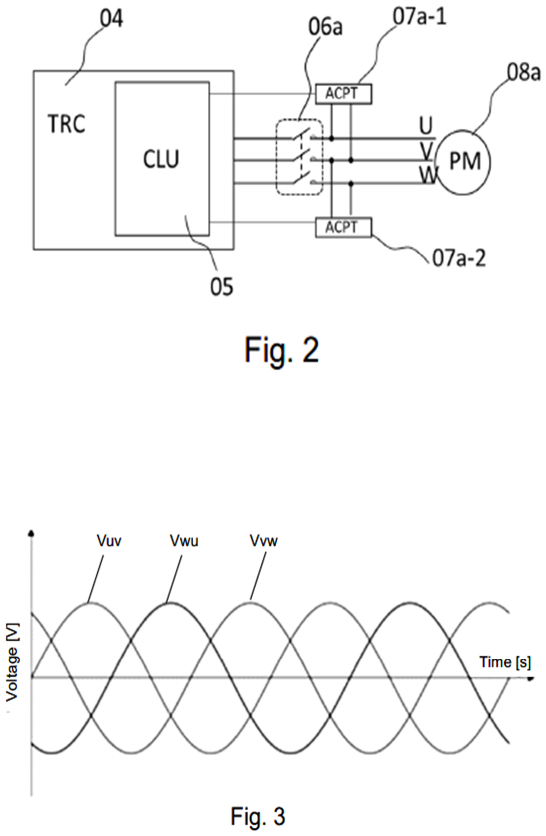

Fig. 2 shows a partial drive system. It includes the traction converter unit 04 and one PMSM 08a connected to the traction converter unit via three contactors within contactor box 06a. Here, as the driving current is three-phase, three contactors or a three-phase contactor that can operate on all the three phases simply at the same time are provided. The phases are denoted as U, V, and W as is conventional. The voltage sensor consists of two components, 07a-1 which senses the voltage between the U and V phases and 07a-2 which senses the voltage between the V and W phases. These sensed voltages are provided to the control logic unit 05, and as has been discussed previously the U-W phase voltage can be inferred. Fig. 3 shows a plot of voltage against time showing a healthy waveform for each of the three phases that can be observed when no short-circuit fault occurs between each pair of phases. As expected, the voltage for the U-V phase (Vuv), W-U phase (Vwu) and V-W phase (Vvw) are sinusoidal and 90° out of phase with one another. After the contactors are opened, this voltage is generated by the rotating motor through an induced voltage.

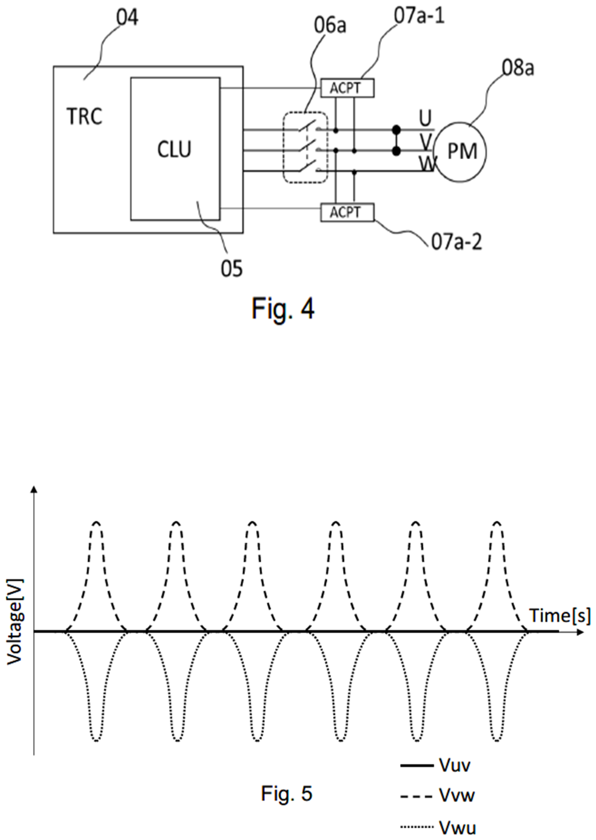

Fig. 4 shows the partial drive system of Fig. 2 in a U-V short-circuit condition. This is indicated by the black circles and link between the U and V phases between the contactor box 06a and the PMSM 08a. Fig. 5 shows the sensed voltages for the condition in Fig. 4. Notably the V-U voltage is or is approximately zero due to the short-circuit fault, and the V-W and W-U waveforms differ noticeably from the healthy waveforms (e.g., no longer crossing the x-axis).

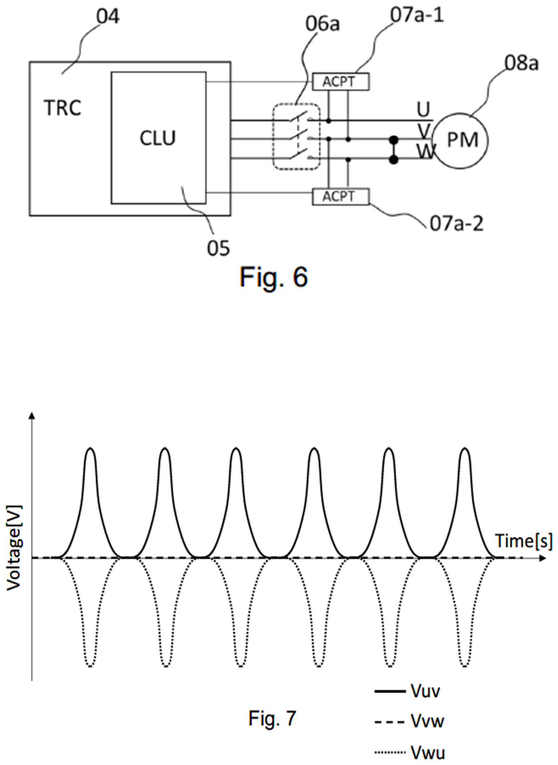

Fig. 6 shows the partial drive system of Fig. 2 in a V-W short-circuit condition. This is indicated by the black circles and link between the V and W phases between the contactor box 06a and the PMSM 08a. Fig. 7 shows the sensed voltages for the condition in Fig. 6. Notably, the V-W voltage is or is approximately zero due to the short-circuit fault, and the U-V and W-U waveforms differ noticeably from the healthy waveforms (e.g., no longer crossing the x-axis).

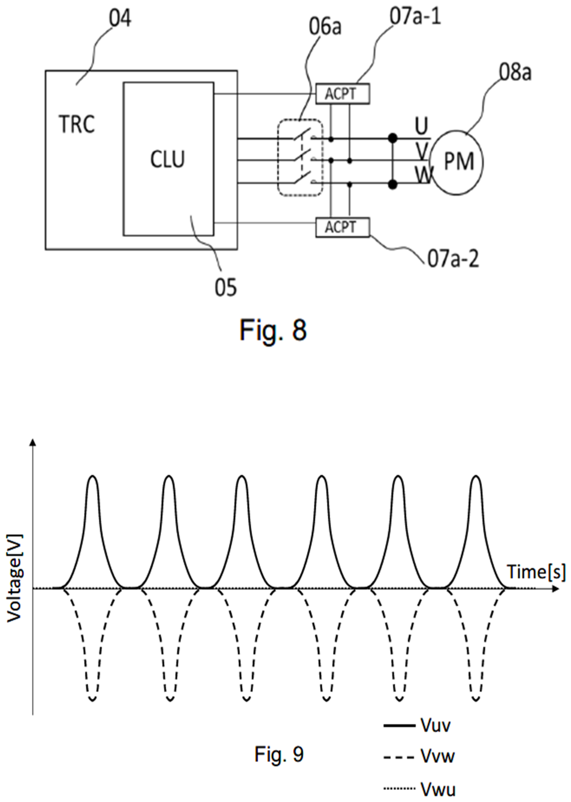

Fig. 8 shows the partial drive system of Fig. 2 in a W-U short-circuit condition. This is indicated by the black circles and link between the U and W phases between the contact box 07a and the PMSM 08a. Fig. 9 shows the sensed voltages for the condition in Fig. 8. Notably, the W-U voltage is or is approximately zero due to the short-circuit fault, and the U-V and V-W waveforms differ noticeably from the healthy waveforms (e.g., no longer crossing the x-axis).

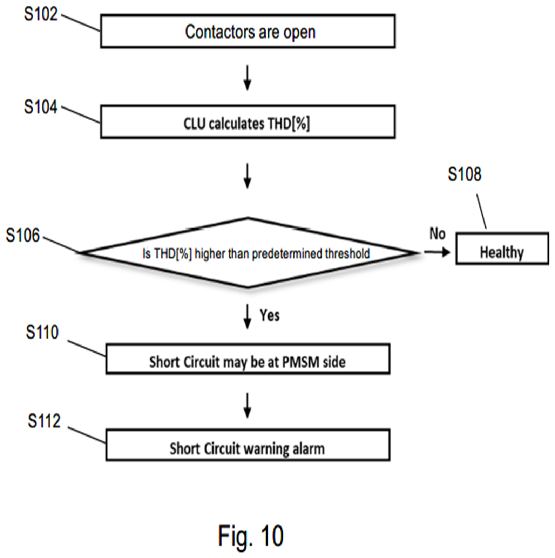

Fig. 10 shows a flow diagram of a method for detecting or verifying short-circuit faults in a PMSM. In a first and optional step, S102, the contactors between a given PMSM and the traction converter unit are opened to isolate the motor from the power supply. Subsequently, the control logic unit calculates the $THD[\%]$ in step S104. This calculation is performed by performing a fast Fourier transform on a sensed voltage of the respective phase pair (e.g., U-V, V-W, or W-U). Then, $THD[\%]$ is calculated using the equation:

$$THD[\%] = \frac{\sqrt{(\Sigma(V_k)^2)}}{V_1} \times 100$$

where $THD[\%]$ is the distortion rate, $V_1$ is the fundamental frequency factor of the voltage, and $V_k$ is the $k^{th}$ frequency factor of voltage. A THD of 5% can be considered to indicate that no short-circuit fault occurs between each pair of the phases, and 10% can be considered to indicate that a short-circuit fault occurs. Therefore, in step S106, the calculated $THD$ [%] can be compared to a predetermined threshold. Applying 5% as the predetermined threshold allows the control logic unit to detect more possible short-circuit fault, whereas applying 10% allows it to focus on the higher probability of the short-circuit fault in PMSMs. If the calculated $THD$ [%] is not higher than the predetermined threshold ("No") the method moves to step S108 and the waveform for this phase pair is determined to be healthy (i.e., there exists no short-circuit fault). However, if the calculated $THD$ [%] is higher than the predetermined threshold ("Yes") the method moves to step S110 where it is detected or verified there may be a short-circuit fault on the PMSM side of the contactors. Consequently, a short-circuit warning alarm is sounded in step S112.

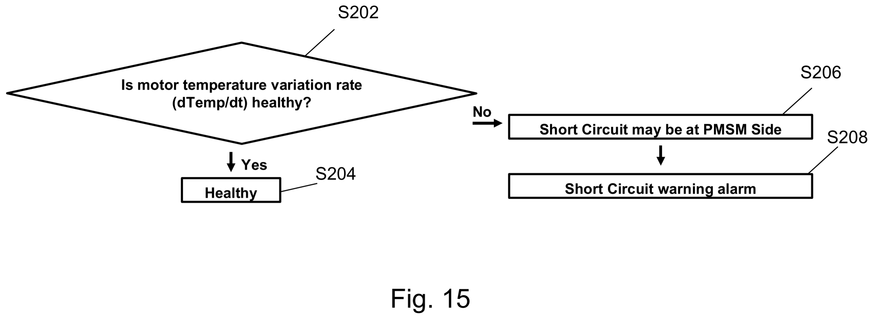

Steps S104 - S108/S112 may be repeated for each of the phase pairs of the multi-phase driving current, such that not only can a short-circuit be identified *per se* but also in which pair of phases of the multi-phase driving current. Steps 104 (optionally including, initially, step S102) to S108/S112 may be triggered in response to a determination according to the method of Figure 15 that there may be a short-circuit fault on the PMSM side of the contactors. For example, the temperature-based method may determine the likelihood of a short-circuit fault *per se,* and the method of Figure 10 may then be used to: (i) detect the presence of fault; and/or (ii) detect which of the phase pairs of the multi-phase driving current are shorted. The entire method may also be repeated periodically throughout use of the train, and specifically may be triggered after the contractors are opened.

The method shown in Fig. 10 may be initiated by an initial determination made whilst the contactors are closed. In this embodiment, whilst the contactors are closed, the same steps S104 - S106 may be performed (that is, a short-circuit may be detected). Responsive to this detection, the contactors are then be opened. The steps S104 - S106 are then performed again, and where the short-circuit is redetected the control logic unit reports a finding that there is a short-circuit on the PMSM side of the contactors. However, if the short-circuit is not redetected the control logic unit reports a finding that the short-circuit is on the other side of the contactors, i.e. between the traction converter unit and the one or contactors. When the short-circuit is detected on the other side of the contactors, the control logic unit can cut off converter 04 so that the converter 04 stops supplying power into the short-circuit fault location.

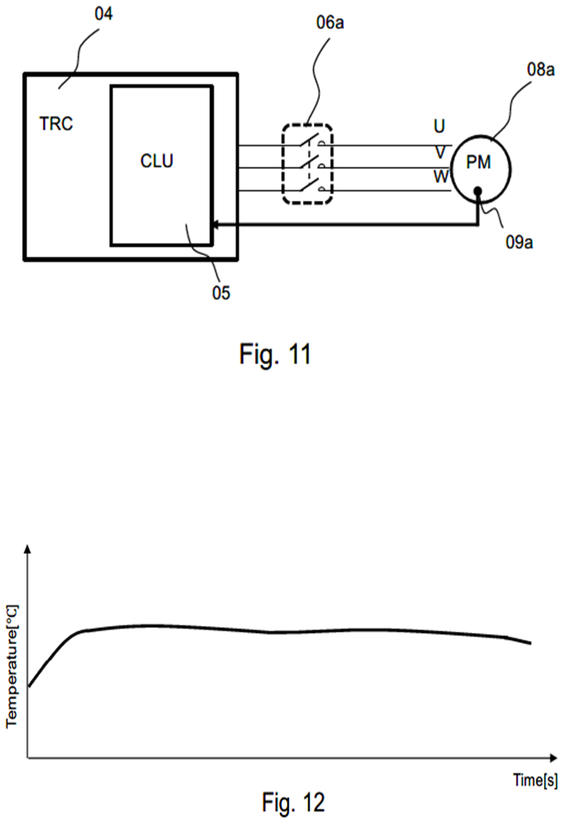

Fig. 11 shows a variant partial drive system. It includes the traction converter unit 04, and one PMSM 08a connected to the traction converter unit via three contactors within contactor box 06a. Here, as the driving current is three-phase, three contactors are provided. The phases are denoted as U, V, and W as is conventional. Here, a temperature sensor 09a is provided within or in proximity to the PMSM so as to sense the temperature of it and send the sensed temperature to control logic unit 05. Fig. 12 shows a plot of temperature against time in a healthy state, noticeably the temperature gradually increases as the motor runs, achieving a steady state at which it remains during operation, which can be observed when no short-circuit fault occurs in a PMSM.

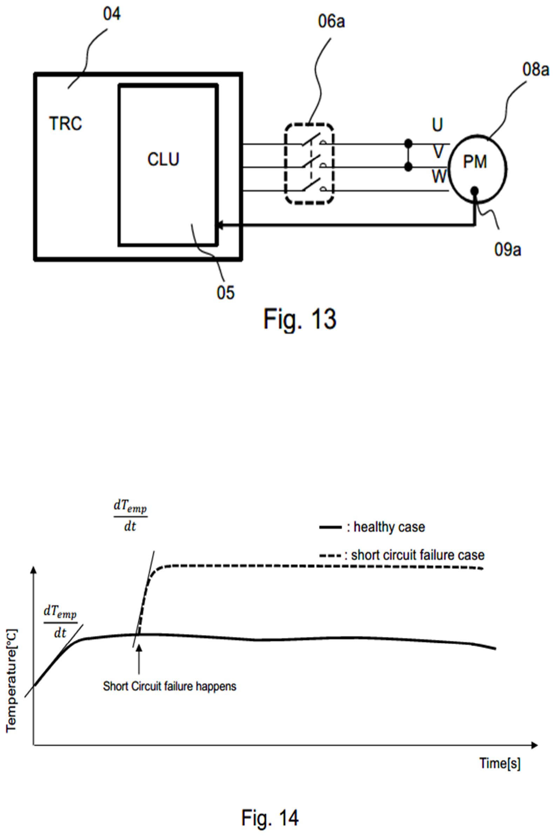

Fig. 13 shows the variant partial drive system of Fig. 11 in a U-V short-circuit condition. This is indicated by the black circles and link between the U and V phases between the contactor box 06a and the PMSM 08a. Fig. 14 shows a plot of temperature against time during the U-V short-circuit condition in Fig. 13. The initial behaviour is similar to the healthy state, in that a gradual rise in temperature is seen as the motor begins to operate. This gradual rise provides a motor temperature variation rate, $\frac{dT_{emp}}{dt}$ , in a heathy status which can be observed when no short-circuit fault occurs in a PMSM (alternatively, known healthy values may be stored ahead of time). However, after the short-circuit failure occurs (indicated by the arrow) the temperature rises more sharply. This subsequent motor temperature variation rate is greater than that of $\frac{dT_{emp}}{dt}$ in the healthy status and indicative of a short-circuit failure. After the rise, the temperature again plateaus but at a higher value than in the healthy state (e.g., due to saturation of the temperature sensor / PMSM).

Fig. 15 shows a flow diagram of a method for detecting or verifying short-circuit faults in a PMSM. In a first step S202, a calculated motor temperature variation rate $(\frac{dT_{emp}}{dt})$ is compared to a predetermined motor temperature variation rate that indicates there exists no short-circuit fault. If it is the same as or lower than the predetermined motor temperature variation rate ("Yes"), the method moves to step S204 and a determination that the PMSM is healthy, which means there exists no short-circuit fault, is made. However, if the calculated motor temperature variation rate is greater than the predetermined motor temperature variation rate ("No"), the method moves to step S206 where it is detected or verified there may be a short-circuit fault on the PMSM side of the contactors. Consequently, a short-circuit warning alarm is sounded in step S208.

The method of Figure 15 may be triggered in response to a determination according to the method of Figure 10 that there may be a short-circuit fault on the PMSM side of the contactors. For example, the voltage-based method may determine the likelihood of a short-circuit fault (and may identify the suspected phase pair which is shorted) and the method of Figure 15 may then be used to verify the presence of the fault.

The systems and methods of the above embodiments may be implemented in a computer system (in particular in computer hardware or in computer software) in addition to the structural components and user interactions described.

The term "computer system" includes the hardware, software and data storage devices for embodying a system or carrying out a method according to the above described embodiments. For example, a computer system may comprise a central processing unit (CPU), input means, output means and data storage. The computer system may have a monitor to provide a visual output display. The data storage may comprise RAM, disk drives or other computer readable media. The computer system may include a plurality of computing devices connected by a network and able to communicate with each other over that network.

The methods of the above embodiments may be provided as computer programs or as computer program products or computer readable media carrying a computer program which is arranged, when run on a computer, to perform the method(s) described above.

The term "computer readable media" includes, without limitation, any non-transitory medium or media which can be read and accessed directly by a computer or computer system. The media can include, but are not limited to, magnetic storage media such as floppy discs, hard disc storage media and magnetic tape; optical storage media such as optical discs or CD-ROMs; electrical storage media such as memory, including RAM, ROM and flash memory; and hybrids and combinations of the above such as magnetic/optical storage media.

While the disclosure has been described in conjunction with the exemplary embodiments described above, many equivalent modifications and variations will be apparent to those skilled in the art when given this disclosure. Accordingly, the exemplary embodiments of the disclosure set forth above are considered to be illustrative and not limiting. Various changes to the described embodiments may be made without departing from the spirit and scope of the disclosure.

In particular, although the methods of the above embodiments have been described as being implemented on the systems of the embodiments described, the methods and systems of the present disclosure need not be implemented in conjunction with each other, but can be implemented on alternative systems or using alternative methods respectively.

The features disclosed in the description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the disclosure in diverse forms thereof.

While the disclosure has been described in conjunction with the exemplary embodiments described above, many equivalent modifications and variations will be apparent to those skilled in the art when given this disclosure. Accordingly, the exemplary embodiments of the disclosure set forth above are considered to be illustrative and not limiting. Various changes to the described embodiments may be made without departing from the spirit and scope of the disclosure.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. A drive system (100), the drive system (100) comprising:

   a main power supply (03);
   a converter (04), configured to receive power from the main power supply and provide a multi-phase driving current;
   a permanent magnet motor (08a, 08b, 08c, 08d), configure to receive the multi-phase driving current;
   one or more contactors (06a, 06b) located between the converter and the permanent magnet motor, configured to selectively isolate the permanent magnet motor from the converter;
   a voltage sensor (07a, 07b), configured to sense a voltage between one or more pairs of phases of the multi-phase driving current at a position between the one or more contactors and the permanent magnet motor; and
   a controller (05), configured, whilst the one or more contactors are open, to receive the sensed voltage from the voltage sensor and detect a short-circuit fault of the permanent magnet motor on the basis of the received sensed voltage and configured, whilst the one or more contactors are closed, to:

receive the sensed voltage(s) from the voltage sensor and detect a short-circuit fault on the basis of the received sensed voltages;

responsive to detecting the short-circuit fault whilst the contactors are closed, open the one or more contactors;

attempt to redetect the short-circuit fault after the one or more contactors are opened; and

responsive to redetecting the short-circuit fault, detect the short-circuit fault is present in the permanent magnet motor; or

responsive to failing to redetect the short-circuit fault, detect the short-circuit fault is present between the converter and the one or more contactors.

2. The drive system of claim 1, wherein the controller is configured to detect the short-circuit fault by comparing a waveform in the received sensed voltage for the or each pair of phases to a predetermined healthy waveform that can be observed when no short-circuit fault occurs between the or each pair of phases.

3. The drive system of claim 2, wherein comparing the waveform in the received sensed voltage for the or each pair of phases includes calculating a distortion rate of the respective waveform and comparing the distortion rate to a threshold corresponding to the predetermined healthy waveform.

4. The drive system of claim 3, wherein the distortion rate is calculated using the equation:

$$THD[\%] = \frac{\sqrt{\sum (V_k)^2}}{V_1} \times 100$$

where *THD,* Total Harmonic Distortion, is the distortion rate, $V_1$ is the fundamental frequency factor of the voltage, and $V_k$ is the k$^{th}$ factor of voltage.

5. The drive system of any preceding claim, further comprising a temperature sensor configured to sense a temperature of the permanent magnet motor, and wherein the controller is configured to receive the sensed temperature from the temperature sensor and detect or verify a short-circuit fault of the permanent magnet motor on the basis of the received sensed temperature.

6. The drive system of claim 5, wherein the controller is configured to derive a rate of change of temperature with respect to time, and to detect or verify the short-circuit fault of the permanent magnet motor by comparing the rate of change of temperature with respect to a predetermined rate that indicates there exists no short-circuit fault.

7. The drive system of any preceding claim, wherein the controller is further configured to detect a motor rotor position and/or rotor speed based on the received sensed voltage.

8. The drive system of claim 1, wherein responsive to detecting the short-circuit fault is present between the converter and the one or more contactors, the controller is configured to disconnect the main power supply from a source power supply.

9. The drive system of any preceding claim, wherein the controller is configured to issue an alert when it detects the short-circuit fault.

10. The drive system of any preceding claim, wherein the converter is configured to provide a three-phase driving current, and the voltage sensor is configured to sense the voltage between each pair of phases of the three-phase driving current.

11. A vehicle, comprising the drive system of any preceding claim.

12. A vehicle of claim 11, further comprising a wheel, a mechanical brake and a brake controller, wherein the brake controller configured to activate the mechanical brake to apply a braking force to the wheel based on a signal from the controller when it detects the short-circuit fault.

13. The vehicle of either claim 11 or 12, the vehicle being a railway vehicle.

14. A method of detecting a short-circuit fault in a permanent magnet motor for a drive system, the method comprising:

receiving a sensed voltage between one or more pairs of phases of a multi-phase driving current at a position between one or more contactors and the permanent magnet motor, the contactor(s) being between a converter and the permanent magnet motor and the converter receiving power from a main power supply and providing the multi-phase driving current;

detecting, whilst the one or more contactors are open, from the sensed voltage(s), a short-circuit fault of the permanent magnet motor;

receiving, whilst the one or more contactors are closed, the sensed voltage(s) from the voltage sensor and detecting a short-circuit fault on the basis of the received sensed voltages;

responsive to detecting the short-circuit fault whilst the contactors are closed, opening the one or more contactors;

attempting to redetect the short-circuit fault after the one or more contactors are opened; and responsive to redetecting the short-circuit fault, detecting the short-circuit fault is present in the permanent magnet motor; or

responsive to failing to redetect the short-circuit fault, detecting the short-circuit fault is present between the converter and the one or more contactors.

Fig. 1

Fig. 2

Fig. 3

Fig. 4

Fig. 5

——— Vuv
- - - Vvw
·········· Vwu

Fig. 6

Fig. 7

—— Vuv

--- Vvw

........ Vwu

Fig. 8

Fig. 9

— Vuv
- - - Vvw
......... Vwu

S102 — Contactors are open

↓

S104 — CLU calculates THD[%]

↓

S108

S106 — Is THD[%] higher than predetermined threshold — No → Healthy

↓ Yes

S110 — Short Circuit may be at PMSM side

↓

S112 — Short Circuit warning alarm

Fig. 10

Fig. 11

Fig. 12

Fig. 13

Fig. 14

S202

Is motor temperature variation rate
(dTemp/dt) healthy?

No

Short Circuit may be at PMSM Side

S206

S208

↓ Yes

Healthy

S204

↓

Short Circuit warning alarm

Fig. 15

# EUROPEAN SEARCH REPORT

**Application Number**

EP 25 22 3018

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 105 691 211 A (ALSTOM TRANSP TECH) 22 June 2016 (2016-06-22) | 1,2,5-14 | INV. H02P3/22 |
| Y | * the whole document * | 3,4 | B60L3/00 G01R31/52 |
| A | CA 3 192 703 A1 (MAGNA INT INC [CA]) 5 May 2022 (2022-05-05) * the whole document * | 1-14 | H02P29/024 |
| Y | SHARMA A. ET AL: "Power quality enhancement at PCC for PMSM based adjustable speed drive load", 2017 7TH INTERNATIONAL CONFERENCE ON POWER SYSTEMS (ICPS) IEEE, 21 December 2017 (2017-12-21), pages 364-369, XP033359377, DOI: 10.1109/ICPES.2017.8387321 [retrieved on 2018-06-15] * the whole document * | 3,4 | |
| A | EP 4 219 216 A1 (BOMBARDIER TRANSP GMBH [DE]) 2 August 2023 (2023-08-02) * the whole document * | 1-14 | **TECHNICAL FIELDS SEARCHED (IPC)** H02P G01R B60L |
| A | US 2017/297593 A1 (STREIFF FABIAN [CH] ET AL) 19 October 2017 (2017-10-19) * the whole document * | 1-14 | |

The present search report has been drawn up for all claims

| Place of search | Date of completion of the search | Examiner |
|---|---|---|
| Munich | 22 April 2026 | Fraïssé, Stéphane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 3018

This annex lists the patent family members relating to the patent documents cited in the above-mentioned European search report.
The members are as contained in the European Patent Office EDP file on
The European Patent Office is in no way liable for these particulars which are merely given for the purpose of information.

22-04-2026

| Patent document cited in search report | | Publication date | Patent family member(s) | | Publication date |
|---|---|---|---|---|---|
| CN 105691211 | A | 22-06-2016 | CN | 105691211 A | 22-06-2016 |
| | | | EP | 3035473 A1 | 22-06-2016 |
| | | | FR | 3030140 A1 | 17-06-2016 |
| | | | JP | 6702708 B2 | 03-06-2020 |
| | | | JP | 2016116448 A | 23-06-2016 |
| | | | US | 2016167523 A1 | 16-06-2016 |
| CA 3192703 | A1 | 05-05-2022 | CA | 3192703 A1 | 05-05-2022 |
| | | | CN | 116507929 A | 28-07-2023 |
| | | | EP | 4196808 A1 | 21-06-2023 |
| | | | KR | 20230096030 A | 29-06-2023 |
| | | | US | 2023396204 A1 | 07-12-2023 |
| | | | WO | 2022087726 A1 | 05-05-2022 |
| EP 4219216 | A1 | 02-08-2023 | CN | 110605969 A | 24-12-2019 |
| | | | DE | 102018209582 A1 | 19-12-2019 |
| | | | EP | 3581427 A1 | 18-12-2019 |
| | | | EP | 4219216 A1 | 02-08-2023 |
| US 2017297593 | A1 | 19-10-2017 | CN | 106715184 A | 24-05-2017 |
| | | | DE | 102014217431 A1 | 03-03-2016 |
| | | | EP | 3188924 A1 | 12-07-2017 |
| | | | ES | 2773432 T3 | 13-07-2020 |
| | | | RU | 2017110887 A | 03-10-2018 |
| | | | US | 2017297593 A1 | 19-10-2017 |
| | | | WO | 2016034548 A1 | 10-03-2016 |

EPO FORM P0459

For more details about this annex : see Official Journal of the European Patent Office, No. 12/82